# EUROPÄISCHE PATENTSCHRIFT

(11) **EP 2 102 902 B1**
(45) Veröffentlichungstag und Bekanntmachung des Hinweises auf die Patenterteilung: **25.04.2012**
(21) Anmeldenummer: 07847737.9
(22) Anmeldetag: 04.12.2007
(51) Int. Cl.: H01L 21/683, H01L 21/687, H01L 21/67

(54) **HANDHABUNGSWERKZEUG FÜR BAUELEMENTE, INSBESONDERE ELEKTRONISCHE BAUELEMENTE**
HANDLING TOOL FOR COMPONENTS, IN PARTICULAR ELECTRONIC COMPONENTS
OUTIL DE MANIPULATION POUR COMPOSANTS, NOTAMMENT POUR COMPOSANTS ÉLECTRONIQUES

(30) Priorität: 11.12.2006 DE 102006058299
(43) Veröffentlichungstag der Anmeldung: 23.09.2009
(73) Patentinhaber: Robert Bosch GmbH, 70442 Stuttgart (DE)
(72) Erfinder: STOPPEL, Klaus, 74354 Besigheim (DE)
(86) Internationale Anmeldenummer: PCT/EP2007/063230
(87) Internationale Veröffentlichungsnummer: WO 2008/071590

(56) Entgegenhaltungen:
- EP-A- 1 321 966
- DE-A1- 19 610 112
- US-A- 4 797 994

## Beschreibung

Die Erfindung betrifft ein Handhabungswerkzeug für Bauelemente, insbesondere elektronische Bauelemente, nach Oberbegriff des Anspruchs 1.

Die Erfindung betrifft weiter ein Verfahren zum Handhaben von Bauelementen, insbesondere elektronischen Bauelementen, nach Oberbegriff des Anspruchs 7.

### Stand der Technik

Handhabungswerkzeuge für Bauelemente, insbesondere elektronische Bauelemente, sind bekannt. Sie werden beispielsweise in Bestückern und Die-Bondern eingesetzt und dienen der Herstellung von elektronischen Schaltkreisen, wobei Bauelemente durch die Handhabungswerkzeuge, die pick-up and bonding devices, aufgenommen werden, insbesondere durch Unterdruck aufgenommen werden, mit dem Handhabungswerkzeug auf einer Leiterplatte platziert und dort fixiert werden. Die im Stand der Technik bekannten Handhabungswerkzeuge sind so aufgebaut, dass sie eine Halteöffnung aufweisen, die mit Unterdruck beaufschlagt wird, so dass die Bauelemente dann, wenn sie mit der Halteöffnung berührt werden, durch den in dem Handhabungswerkzeug herrschenden Unterdruck im Zusammenspiel mit dem Umgebungsluftdruck in der Halteöffnung gehalten werden. Eine derartige Vorrichtung ist beispielsweise aus US 3958740 bekannt. Die Bauteile werden hierbei an der Halteöffnung abhängig von ihrer Dicke, also insbesondere ihrer Materialstärke und -flexibilität, in die Halteöffnung hineingebogen, wodurch eine Verformung/Krümmung des Bauelements in die Halteöffnung hinein entsteht. Diese Verformung bildet an der Seite des Bauelements, die auf der Leiterbahn beziehungsweise dem Substrat fixiert werden soll, einen Hohlraum (konkave Ausbildung), der beim Aufsetzen zu Lunkern und Gaseinschlüssen führt. Insbesondere dann, wenn das Bauelement auf Epoxid, Lot, oder Sealglas aufgesetzt wird, entstehen hierbei irreversible Fehler, die zu einer hohen Ausschussquote führen oder zumindest die Qualität des Bondings beeinträchtigen. Ferner kann das Bauelement, wenn es eine nur geringe Materialstärke aufweist, durch den Unterdruck an der Halteöffnung soweit durchgebogen werden, dass es beschädigt wird.

Aus EP 1 321 966 A1 ist ein Greifwerkzeug mit einem elastisch deformierbaren beziehungsweise verformbaren Saugorgan bekannt. Das Saugorgan wird von mehreren Kanälen durchsetzt, die in jeweils eine Öffnung münden. Die Öffnungen sind dabei in einer konvex geformten Fläche - in einer Draufsicht betrachtet - in einer Ebene derart um einen zentralen Bereich der Fläche herum angeordnet, dass die Fläche in dem zentralen Bereich über die Ebene hinausragt. Nachteilig bei dieser Ausführung ist, dass beim Aufnehmen und Ablegen eines Bauelements durch die Verformung des Saugorgans große Kräfte auf das Bauelement wirken.

Aufgabe der Erfindung ist es, ein Handhabungswerkzeug für Bauelemente, insbesondere elektronische Bauelemente, bereitzustellen, das die genannten Nachteile vermeidet.

### Offenbarung der Erfindung

Hierzu wird ein Handhabungswerkzeug für Bauelemente, insbesondere elektronische Bauelemente, vorgeschlagen, mit einer mit Unterdruck beaufschlagbaren Halteöffnung, an der zu handhabende Bauteile per Unterdruck gehalten werden können. Es ist vorgesehen, dass in der Unterdrucköffnung mindestens ein Gegenhalter angeordnet ist, der in einer Betriebsstellung die Öffnungsebene nach außen überragt (unter Betriebsstellung wird hierbei eine solche Stellung des Handhabungswerkzeugs verstanden, in der das zu handhabende Bauelement durch Unterdruck an der Halteöffnung gehalten wird). Der Gegenhalter ist erfindungsgemäß von mindestens einem Unterdruckzuleitkanal durchsetzt. Auf dem Gegenhalter ist eine die Halteöffnung aufweisende Hülse axial verschieblich gelagert. Anders als im Stand der Technik ist die Halteöffnung folglich nicht vollständig offen, sondern weist mindestens einen Gegenhalter auf, der in einer Betriebsstellung der Verformung des Bauteils in Richtung des hierauf einwirkenden Unterdrucks (also in die Halteöffnung hinein) entgegenwirkt. Mehr noch ermöglicht er die (leichte) Verformung des Bauteils in genau umgekehrter Richtung, so dass, von der Bestückungsebene aus betrachtet, keine konkave, sondern eine konvexe Ausbildung erfolgt, das Bauteil folglich nicht mit seinen Randseiten zuerst, sondern mit der Mitte (die von dem Gegenhalter nach außen, also zum Substrat hin gedrückt wird) auf das Substrat aufgelegt wird. Wenn die Bestückungsseite aus einer ebenen Kleberfläche besteht, wie dies im Stand der Technik üblich ist, erfolgt demzufolge zunächst ein mittiges Aufsetzen des Bauelements, so dass eventuelle Gase beim Auflegen des Bauelements durch das Handhabungswerkzeug nach außen zu den Rändern hinweggedrückt werden, anstatt von dem zuerst aufgesetzten Rändern in der Mitte des Bauelements festgehalten zu werden. Die Bildung von Lunkern durch Oberflächeneinschlüsse bei Absetzen auf das Klebemedium wird hierbei vermieden. Weiter kann ein Verkanten durch ein nicht paralleles Aufsetzen des Bauelements vermieden werden, da ein Versatz zum Substrat durch die konkave Ausbildung beim Auflegen des Bauelements ausgeglichen wird.

Erfindungsgemäß ist vorgesehen, dass auf dem Gegenhalter eine die Halteöffnung aufweisende Hülse axial verschieblich gelagert ist. Abhängig von der Materialstärke des aufzunehmenden Bauelements und dessen Verformung durch die Beaufschlagung mit Unterdruck wird die gegen ihre Gewichtskraft axial verschiebliche Hülse axial nach hinten verschoben, so dass der Gegenhalter ein Stück weiter als im Ruhezustand aus der Halteöffnung hervortritt. Die Verformung des Bauelements ist hierbei lediglich abhängig von der Materialstärke des Bauelements und von der Stärke des Unterdrucks, mit der das Bauelement an der Halteöffnung beaufschlagt wird. Hierdurch ergibt sich eine ausreichende Verformung und Ausbildung einer konvexen Ausbildung bezüglich der auf das Substrat aufzubringenden Seite des Bauelements. Bei Abschalten des Unterdrucks zum Lösen des Bauelements gleitet die Hülse aufgrund ihrer Gewichtskraft über den Gegenhalter hinaus vor, so dass das Bauelement vom Gegenhalter entfernt wird.

In einer weiteren bevorzugten Ausführungsform ist die Hülse gegen Federkraft axial verschieblich gelagert. Anstelle ihres Eigengewichts bewirkt hier eine definierte Federkraft die Rückstellung der Axialverschiebung, wobei diese auch über weitere äußere Mittel, wie sie aus dem Stand der Technik bekannt sind, einstellbar gestaltet sein kann, beispielsweise über ein Gewinde, mittels dessen sich der Federweg regulieren und damit die Federkraftbeaufschlagung fein dosieren lässt.

In einer weiteren, besonders bevorzugten Ausführungsform ist vorgesehen, dass der Unterdruck in seiner Stärke mittels einer Steuereinrichtung individuell, insbesondere bauteilabhängig, steuerbar ist. Der Unterdruck, mit dem das Bauelement an der Unterdrucköffnung beaufschlagt wird, kann hierbei gesteuert/reguliert werden, um eine möglichst vorteilhafte und stets die gewünschte Verformung des Bauelements und selbstverständlich die erforderliche Haltekraft aufzubringen, die für eine möglichst sichere und fehlerfreie Handhabung des Bauelements erforderlich ist. Insbesondere Bauelemente von geringer Materialstärke, beispielsweise dünne Chips, erfordern eine eher geringe Unterdruckbeaufschlagung, da sie einerseits nur ein sehr geringes Gewicht haben, die Haltekraft also schnell erreicht ist, andererseits aber einer nicht unerheblichen Bruchgefahr unterliegen, wenn sie zu stark verformt werden. Materialstarke Bauelemente erfordern eher eine höhere Unterdruckbeaufschlagung, da sie nicht ohne Weiteres in der gewünschten Art und Weise von Gegenhalter und axial verschieblicher Hülse an der Halteöffnung verformt werden, so dass sich die gewünschte konvexe Ausbildung ergibt. Diese Ausführungsform ermöglicht es, abhängig von der Bauteilstärke und -beschaffenheit den Unterdruck jeweils so zu regeln, dass alle Bauelemente im Wesentlichen dieselbe konvexe Ausbildung auf der dem Substrat zugewandten Seite erfahren, und insoweit eine sehr zuverlässige Verarbeitung und Vermeidung von Hohlräumen beim Aufsetzen und hierdurch entstehender Lunkern möglich ist.

Erfindungsgemäß ist vorgesehen, dass der Gegenhalter von mindestens einem Unterdruckzuleitkanal durchsetzt ist. Die Unterdruckbeaufschlagung der Unterdrucköffnung erfolgt demzufolge über den Gegenhalter, nicht durch andere konstruktive Vorkehrungen. Dies bietet den Vorteil, dass insbesondere bei Ausführung mit einer axial verschieblichen Hülse, eine weitestgehend dichte und sehr einfach zu bewerkstelligende konstruktive Ausführung möglich ist, in der die Hülse lediglich auf dem Gegenhalter axial verschieblich aufgesetzt wird, wobei die Hülse an ihrem Ende (das nicht der Öffnungsebene zugewandt ist) beispielsweise von einer Schraubendruckfeder federkraftbeaufschlagt wird. Mit nur wenigen Bauteilen lässt sich so ein sehr effektives Handhabungswerkzeug herstellen.

In einer weiteren, ganz besonders bevorzugten Ausführungsform ist der Gegenhalter zentral in der Unterdrucköffnung angeordnet. Bei dieser Ausführungsform ist ohne Weiteres eine genau mittige Ausbildung der konvexen Verformung am Bauelement möglich. Ebenso ist die konstruktive Ausführung des Handhabungswerkzeugs sehr einfach möglich, beispielsweise in Form eines im Wesentlichen zylindrischen beziehungsweise stabförmigen Gegenhalters und einer zylinderförmigen Hülse.

In einer weiteren besonders bevorzugten Ausführungsform weist der Gegenhalter eine verrundete Spitze, insbesondere eine Kegelspitze, auf. Die Ausführung mit einer verrundeten Spitze verhindert Beschädigungen oder Beeinträchtigungen der Oberfläche des Bauelements und erlaubt eine gleichmäßig erfolgende Kraftbeaufschlagung des Bauelements durch den Gegenhalter im Moment der Unterdruckbeaufschlagung und Verformung.

In einer ganz besonders bevorzugten Ausführungsform ist die verrundete Spitze als wechselbare Gegendruckspitze ausgebildet. Die Gegendruckspitze kann dadurch in ihrer Geometrie und ihrer Materialbeschaffenheit leicht auf die jeweiligen Anwendungsbereiche und die Erfordernisse der zu verarbeitenden Bauelemente angepasst werden. Dies ist besonders dort vorteilhaft, wo empfindliche elektronische Bauelemente verarbeitet werden und/oder das Handhabungswerkzeug häufig wechselnde Bauelementarten unterschiedlicher Beschaffenheit und Empfindlichkeit verarbeitet. Das Auswechseln der Gegendruckspitze kann hierbei manuell durch einen Bediener oder aber automatisiert erfolgen, vorzugsweise unter Bereitstellung mehrerer Gegendruckspitzen in einem Magazin oder einer ähnlichen Vorrichtung.

Ferner wird ein Verfahren zum Handhaben von Bauelementen, insbesondere elektronischen Bauelementen vorgeschlagen, das folgende Schritte aufweist:
- Ansaugen eines Bauelements per Unterdruck und Halten des Bauelements durch den Unterdruck;
- Abstützen des per Unterdruck gehaltenen Bauteils im Bereich seiner mit Unterdruck beaufschlagten Fläche derart, dass sich diese Fläche, insbesondere das Bauteil, von der Unterdruckseite her betrachtet, konkav durchbiegt.

Anders als im Stand der Technik wird folglich das Bauteil im Wesentlichen nicht in Planlage durch Unterdruck gehalten, sondern (von der Unterdruckseite her betrachtet) in Konkavlage. Das Bauteil wird demzufolge in einer solchen Art verformt, dass sich in Gegenüberlage des Substrats, auf das das Bauteil aufgebracht wird, eine konvexe Ausbildung ergibt, insbesondere in der Mitte der Fläche des Bauteils. Das Bauteil erfährt insoweit eine Abstützung am Handhabungswerkzeug an mehreren Stellen, nämlich insbesondere in der Bauteilmitte von der Unterdruckseite her, und zum Rand des Bauteils hin, wobei die Abstützpunkte, die am Rand des Bauteils liegen, stromabwärts der Saugrichtung gelegen sind, so dass sich die erwähnte Durchbiegung des Bauteils ergibt. Auf diese Weise wird sichergestellt, dass das Bauteil mit der dem Substrat gegenüberliegenden, konvex ausgebildeten Mittelfläche zuerst auf das Substrat aufkommt, so dass sich keine über die gesamte Fläche des Bauteils verteilten Lunker und/oder Lunkerseen ausbilden können.

Es ist erfindungsgemäß vorgesehen, dass das Anlegen des Bauteils an den Rändern einer mit Unterdruck beaufschlagten Halteöffnung erfolgt, wobei, in Saugrichtung betrachtet, das Abstützen stromaufwärts des Anlegens erfolgt. Das Anlegen des Bauteils erfolgt folglich an einer Halteöffnung, die beispielsweise rohrförmig, insbesondere zylindrisch ausgebildet sein kann. Durch Unterdruckbeaufschlagung dieser Halteöffnung wird das Bauteil vermittels des Unterdrucks an der Halteöffnung gehalten, wobei ein Abstützen stromaufwärts des Anlegens erfolgt (in Saugrichtung betrachtet). Dies wird dadurch bewirkt, dass sich die Halteöffnung in Saugrichtung (also stromabwärts) verschiebt, insbesondere über eine längsverschiebliche Lagerung der Halteöffnung relativ zu einem Abstützpunkt, der das Bauteil flächenmittig abstützt, wie zum vorstehend offenbarten Handhabungswerkzeug offenbart.

In einer weiteren, bevorzugten Ausbildung des Verfahrens ist vorgesehen, dass die Stärke des Unterdrucks einstellbar gewählt werden kann. Hierdurch lässt sich der das Halten des Bauteils an der Halteöffnung bewirkende Unterdruck regulieren und insbesondere der Beschaffenheit und Struktur des Bauteils anpassen. Ferner lässt sich hierüber, in gewissen Grenzen, auch die Stärke des Durchbiegens bei längsverschieblicher Anordnung der Haltepunkte, insbesondere der Halteöffnung, relativ zum Abstützpunkt einstellen. Insbesondere kann dadurch auch eine Beschädigung des Bauelements durch die Durchbiegung verhindert werden.

Weitere vorteilhafte Ausführungsformen ergeben sich aus den Unteransprüchen und aus Kombinationen derselben.

### Kurze Beschreibung der Zeichnungen

Die Erfindung wird nachfolgend anhand einer Figur näher erläutert. Es zeigen
- Figur 1: ein erfindungsgemäßes Handhabungswerkzeug im Längsschnitt,
- Figur 2: eine Ausführungsform des Gegenhalters mit wechselbarer Gegendruckspitze und
- Figur 3: eine charakteristische, deutlich verbesserte Anordnung von Restlunkern bei Verwendung des erfindungsgemäßen Handhabungswerkzeugs.

### Ausführungsform(en) der Erfindung

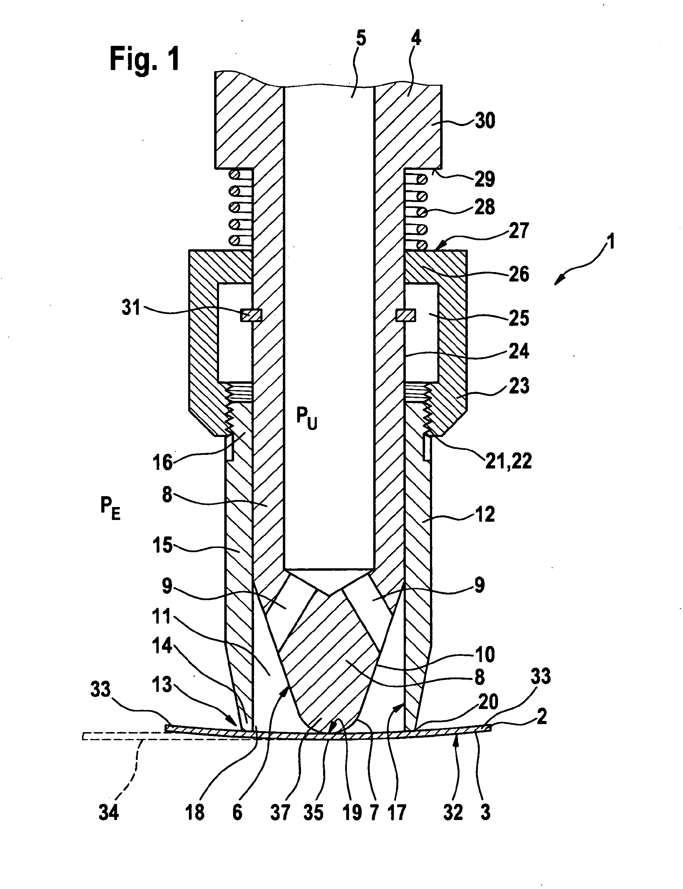

Die Figur 1 zeigt ein Handhabungswerkzeug 1 für ein elektronisches Bauelement 2, nämlich einen Chip 3. Das Handhabungswerkzeug 1 besteht aus einem Unterdruckkörper 4, der eine zylindrische Bohrung 5 aufweist, die mit einem nicht dargestellten Unterdruckerzeugungssystem verbunden ist. Der Unterdruckkörper 4 weist an seinem Endbereich 6 eine Kegelausbildung 7 auf, und bildet hiermit einen Gegenhalter 8 zur Abstützung des Bauelements 2. Die Kegelausbildung 7 weist spitzenseitig eine verrundete Spitze 37 auf. Der Gegenhalter 8 weist zwei Unterdruckzuleitkanäle 9 auf, die von der Bohrung 5 des Unterdruckkörpers 4 abgehen und außen an Kegelflanken 10 des Gegenhalters 8 enden, und somit die Bohrung 5 mit einem den Gegenhalter umgebenden Ansaugbereich 11 verbinden. Der Gegenhalter 8 wird von einer im Wesentlichen zylindrisch ausgebildeten Hülse 12 umfangen, die auf dem Gegenhalter 8 axial verschieblich angeordnet ist. Die Hülse weist in ihrem vorderen Endbereich 13 eine Wandverjüngung 14 auf, so dass ihre Hülsenwandung 15 in ihrem Endbereich 13 zunehmend schwächer ausgebildet ist als in ihrem rückwärtigen Bereich 16. Der Endbereich 13 ist hierbei der Bereich, der der Kegelausbildung 7 des Gegenhalters 8 räumlich zugeordnet ist. Zusammen mit der Kegelausbildung 8 (begrenzt durch die Kegelflanke 10 des Gegenhalters 8) bildet die Hülse 12 mit ihrem Endbereich 13, insbesondere dessen Innenwandung 17, den Ansaugbereich 11 aus, der, dem Bauteil 2 zugewandt, eine Halteöffnung 18 des Handhabungswerkzeugs 1 ausbildet. Die Halteöffnung 18 ist aufgrund der hier zylindrischen Ausführung der Hülse 12 kreisförmig. Der Gegenhalter 8 ist mit seiner Kegelausbildung 7 zentrisch in der Halteöffnung 18 angeordnet, wobei eine Kegelspitze 19 des Gegenhalters 18 geringfügig nach außen ragt, also eine von der Halteöffnung 18 ausgebildete Öffnungsebene 20 nach außen überragt. Die Axialverschieblichkeit der Hülse 12 auf dem Gegenhalter 8 wird begrenzt durch eine über ein Gewinde 21, insbesondere über ein Feingewinde 22 einstellbare Wegbegrenzungshülse 23. Diese Wegbegrenzungshülse 23 sitzt auf dem am rückwärtigen Bereich 16 der Hülse 12 angebrachten Feingewinde 22, und ist über das Feingewinde 22 axial hierzu verstellbar. Die Wegbegrenzungshülse 23 überfängt den Gegenhalter 8 im Wesentlichen ringförmig, wobei zwischen dem Gegenhalter 8 (nämlich dessen Gegenhalteraußenwand 24 und der Wegbegrenzungshülse 23) ein Regulierraum 25 ausgebildet ist. Der Regulierraum 25 wird einerseits begrenzt durch das Feingewinde 22 im Anschluss an die Hülse 12, und andererseits, in dem dem Feingewinde 22 gegenüberliegenden Bereich, von einem am Gegenhalter 8 beziehungsweise Unterdruckkörper 4 gleitverschieblich anliegenden Führungsring 26. Der Führungsring 26 stützt sich außenseitig, also an seiner Oberseite 27, an einer Spiraldruckfeder 28 ab, die sich ihrerseits an einem Druckwiderlager 29 des Unterdruckkörpers 4 abstützt, das beispielsweise als Umfangsvergrößerung 30 des zylinderförmig ausgebildeten Unterdruckkörpers 4 ausgebildet sein kann. Hieraus folgt die Federkraftbeaufschlagung der Hülse 12 über die Wegbegrenzungshülse 23 durch die Spiraldruckfeder 28, so dass die Hülse 12 im Ruhezustand (also wenn kein Bauelement 2 über Unterdruck gegriffen wird) bestrebt ist, von dem Druckwiderlager 29 möglichst großen Abstand einzuhalten, wobei der größtmögliche Abstand hierbei von einer Begrenzungsmanschette 31 vorgegeben ist. Über das Feingewinde 22 ist es möglich, den Grad der Überragung des Gegenhalters 8 über die Halteöffnung 18 hinaus fein zu justieren.

Wird nun über die Bohrung 5 und die Unterdruckzuleitkanäle 9 der Ansaugbereich 11 mit Unterdruck P_{U} beaufschlagt und das Handhabungswerkzeug 1 auf das Bauelement 2 aufgesetzt, so wird im Moment des Aufsetzens die Halteöffnung 18 durch das Bauelement 2 verschlossen. In dem Ansaugbereich 11 baut sich der Unterdruck P_{U} so weit auf, wie dies durch die Unterdruckbeaufschlagung über die Bohrung 5 vorgegeben ist, wodurch sich die Hülse 12 axial in Richtung des Druckwiderlagers 29 entgegen der Federkraft der Spiraldruckfeder 28 verschiebt, und das Bauteil 2 durch den Umgebungsluftdruck P_{E}, der größer ist als der in der Bohrung 5 und damit in dem Ansaugbereich 11 herrschende Unterdruck P_{U}, an der Halteöffnung 18 gehalten wird. Das Bauteil 2 verformt sich durch den hierauf einwirkenden Umgebungsluftdruck P_{E} unter weiterer geringer Axialverschiebung der Hülse 12 dergestalt, dass es an seiner dem hier nicht dargestellten Substrat zugewandten Unterseite 32 eine geringfügig konvexe Ausbildung erfährt, die durch die Kegelspitze 19 des Gegenhalters 8 bewirkt wird, der nunmehr aufgrund der herrschenden Druckverhältnisse zwischen dem Umgebungsluftdruck P_{E} und dem Unterdruck P_{U} über die in der Halteöffnung 18 gebildete Öffnungsebene 20 geringfügig hinausragt. Hierbei ergibt sich durch die konvexe Verformung des Bauelements 2 ein Herausheben von dessen Randbereichen 33 aus einer ursprünglichen Unterseitenebene 34 des Bauelements 2, die Unterseite 32 des Bauelements 2 ist folglich nicht mehr plan. Dieses Herausheben der Randbereiche 33 aus der Unterseitenebene 34 findet aufgrund der zentrischen Anordnung der Kegelspitze 19 des Gegenhalters 8 innerhalb der Halteöffnung 18 allseitig an dem Bauelement 2 statt, so dass bei einem nun erfolgenden Aufsetzen des Bauelements 2 mit seiner Unterseite 32 auf das nicht dargestellte Substrat die Unterseite 32 an einer im Wesentlichen zentrisch am Bauelement 2 ausgebildeten Vorwölbung 35 zuerst aufgesetzt wird, und hierbei möglicherweise bestehende Gaseinschlüsse in Richtung der Randbereiche 33 weggedrückt werden, so dass beim Loslassen des Bauelements 2 durch das Handhabungswerkzeug 1, nämlich dem Aufheben des Unterdrucks P_{U}, mit entsprechendem Vorgleiten der Hülse 12 aufgrund der Federkraftbelastung durch die Spiraldruckfeder 28 und damit erfolgendem Abstoßen des Bauelements 2 von der Halteöffnung 18 das Bauelement 2 von innen (der Vorwölbung 35 ausgehend) nach außen (zu den Randbereichen 33 hin) auf das Substrat aufgelegt wird. Hierdurch ist es praktisch vollständig ausgeschlossen, dass es zu Lufteinschlüssen und/oder Lunkern kommt.

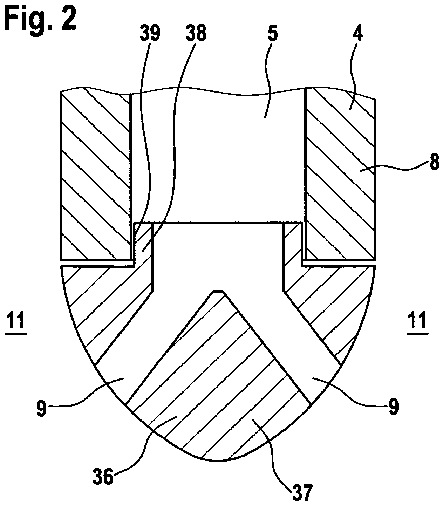

Figur 2 zeigt als Detailansicht eine Ausführungsform des Gegenhalters 8 aus Figur 1 mit einer wechselbaren Gegendruckspitze 36. Die übrigen Komponenten des Handhabungswerkzeugs 1 sind der besseren Übersichtlichkeit halber nicht dargestellt. Die verrundete Spitze 37 ist hier als wechselbare Gegendruckspitze 36 ausgebildet, die mittels einer geeigneten Aufnahme 38 in die Bohrung 5 des Gegenhalters 8 beziehungsweise des Unterdruckkörpers 4 eingebracht ist. Die Aufnahme 38 ist hierbei als Steckaufnahme 39 ausgeführt, wobei aber auch eine Ausführung als Verschraubung oder eine ähnliche, geeignete Fixierung denkbar ist. Die Gegendruckspitze 36 weist die Unterdruckzuleitkanäle 9 auf, die wie in der vorstehend beschriebenen Figur 1 als bereichsweise Durchdringungen des Körpers der Gegendruckspitze 36 ausgeführt sind und eine Druckkommunikation zwischen der Bohrung 5 des Gegenhalters 8 und den die Gegendruckspitze umgebenden Ansaugbereich 11 ermöglichen. Die wechselbare Gegendruckspitze 36 kann hierbei in unterschiedlicher Geometrie und Materialbeschaffenheit ausgeführt werden, um den speziellen Anforderungen auch empfindlichster unterschiedlicher Bauelemente gerecht zu werden. Ferner ist ein leichter und preiswerter Austausch der wechselbaren Gegendruckspitze 36 bei Verschleiß oder Beschädigung möglich, ohne dass das gesamte Handhabungswerkzeug 1 oder doch wenigstens der Unterdruckkörper 4 gewechselt werden müsste. Es ergibt sich hierdurch eine sehr vielseitige Einsetzbarkeit für eine Vielzahl auch empfindlichster Bauelemente sowie eine sehr hohe Wartungsfreundlichkeit des Handhabungswerkzeugs 1 und damit eine deutliche Kostenreduktion.

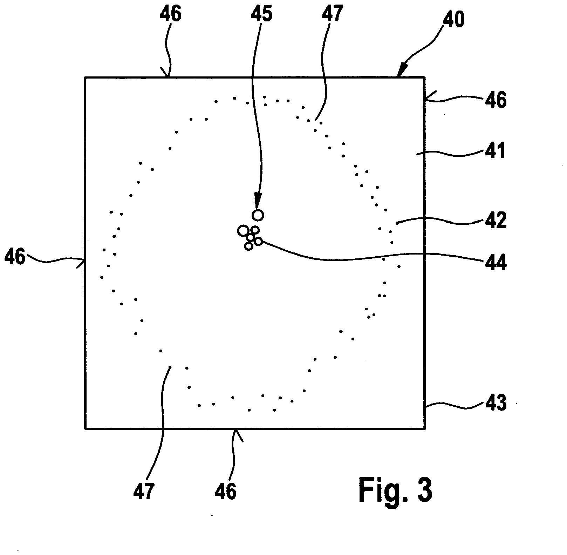

Figur 3 zeigt in vergrößerter, vereinfachter Darstellung einen Ausschnitt 40 einer Oberfläche 41 eines Substrats 42, auf das das hier nicht dargestellte Bauelement 2, insbesondere ein Chip 3 (hier ebenfalls nicht dargestellt) aufgebracht wurde. Auf der Oberfläche 41 des Substrats 42 befinden sich mittig einer Fläche 43, die der Ausdehnung des hier nicht dargestellten Bauelements 2 entspricht, vereinzelte Restlunker 44 (stark übertrieben dargestellt) die zusammen einen Lunkersee 45 ausbilden. Der Lunkersee 45 wird bei Verwendung des erfindungsgemäßen, hier nicht dargestellten Handhabungswerkzeugs 1 stets in einer solchen oder annährend solchen Art mittig der Fläche 43 ausgebildet, wobei dies auf den Einsatz des hier nicht dargestellten Gegenhalters 8, insbesondere der hier nicht dargestellten Kegelspitze 19 und/oder der wechselbaren Gegendruckspitze 36 (hier ebenfalls nicht dargestellt; vergleiche hierzu Figur 1 und Figur 2) zurückzuführen ist. Die Lunkerausbildung erfolgt deshalb mittig in der Fläche 43, weil das nicht dargestellte Bauelement 2 an dieser Stelle zuerst das Substrat 42 berührt. Gas, das zu weiterer Lunkerbildung und/oder weiteren Einschlüssen im Substrat 42 führen könnte, sobald das Bauelement 2 aufgelegt wird, kann bei Verwendung des erfindungsgemäßen Handhabungswerkzeugs 1 zu Flächenaußenrändern 46 hin entweichen, so dass ein Einschluss und damit die Ausbildung von Restlunkern 44 in Bereichen nahe der Flächenaußenränder 46 beziehungsweise großflächig auf der Fläche 43 nicht erfolgt. Unter Umständen kann es auch bei Verwendung des erfindungsgemäßen Handhabungswerkzeugs 1 zur Ausbildung weiterer, vereinzelter, kleiner Restlunker 44 kommen, die in ihrer Geometrie der Geometrie des Endbereichs 13 der Hülse 12 (hier nicht dargestellt) entspricht. Es ergibt sich dabei eine Ausbildung eines Lunkerrings 47 (hier stark übertrieben für eine kreisförmige Geometrie der Hülse 12 dargestellt), in dem vereinzelte Lunker in einer der Hülsengeometrie entsprechenden Anordnung ausgebildet werden. Der Begriff Lunkerring 47 meint in diesem Zusammenhang jede geometrische Ausbildung von vereinzelten Restlunkern 44, die der Geometrie der verwendeten Hülse 12 (hier nicht dargestellt) des hier nicht dargestellten Handhabungswerkzeugs 1 entspricht. Somit ergibt sich eine für das hier nicht dargestellte Handhabungswerkzeug 1 beziehungsweise den Einsatz des erfindungsgemäßen Verfahrens stets charakteristische Darstellung von Restlunkern 44. Die Anordnung der einzelnen Restlunker 44 entspricht dabei stets den Geometrien, wie sie im nicht dargestellten Handhabungswerkzeug 1 vorgefunden werden, nämlich insbesondere der Hülse 12 für einen eventuellen Lunkerring 47 beziehungsweise des Gegenhalters 8 (insbesondere der wechselbaren Gegendruckspitze 36 beziehungsweise der Kegelspitze 19; vergleiche Figur 1 und Figur 2). Eine derart charakteristische Ausbildung von Restlunkern 44 lässt stets auf den Einsatz des erfindungsgemäßen Handhabungswerkzeugs 1 beziehungsweise des erfindungsgemäßen Verfahrens zur Handhabung von Bauelementen schließen. Anders als bei im Stand der Technik aufgefundenen Lunkerausbildungen haben die hier anzutreffenden (sehr geringen) Lunkerausbildungen nämlich eine spezifische Geometrie. Sie folgen keiner zufälligen Verteilung und sind insbesondere nicht über die Fläche 43 im Wesentlichen gleich verteilt. Vielmehr liegt eine Häufung von Restlunkern 44 auf der Fläche 43 nur an solchen Stellen vor, an denen Druckausübung durch das erfindungsgemäße Handhabungswerkzeug 1 erfolgt, nämlich im Bereich der Hülse 12 (mit einer Ausbildung eines Lunkerrings 47) beziehungsweise des Gegenhalters 8 und/oder der Kegelspitze 19 beziehungsweise der wechselbaren Gegendruckspitze 36 durch Ausbildung eines Lunkersees 45 im Wesentlichen zentrisch der Fläche 43.

## Patentansprüche

1. Handhabungswerkzeug für Bauelemente, insbesondere elektronische Bauelemente, mit einer mit Unterdruck beaufschlagbaren Halteöffnung, an der zu handhabende Bauteile per Unterdruck gehalten werden können, **dadurch gekennzeichnet, dass** in der Halteöffnung (18) mindestens ein Gegenhalter (8) angeordnet ist, der in einer Betriebsstellung die Öffnungsebene (20) nach außen überragt und von mindestens einem Unterdruckzuleitkanal (9) durchsetzt ist, und wobei auf dem Gegenhalter (8) eine die Halteöffnung (18) aufweisende Hülse (12) axial verschieblich gelagert ist.

2. Handhabungswerkzeug nach Anspruch 1, **dadurch gekennzeichnet, dass** die Hülse (12) gegen Federkraft axial verschieblich ist.

3. Handhabungswerkzeug nach einem der vorhergehenden Ansprüche, **dadurch gekennzeichnet, dass** der Unterdruck (P_{U}) in seiner Stärke mittels einer Steuereinrichtung individuell, insbesondere bauteilabhängig, steuerbar ist.

4. Handhabungswerkzeug nach einem der vorhergehenden Ansprüche, **dadurch gekennzeichnet, dass** der Gegenhalter (8) zentral in der Halteöffnung (18) angeordnet ist.

5. Handhabungswerkzeug nach einem der vorhergehenden Ansprüche, **dadurch gekennzeichnet, dass** der Gegenhalter (8) eine verrundete Spitze (37), insbesondere eine Kegelspitze (19), aufweist.

6. Handhabungswerkzeug nach einem der vorhergehenden Ansprüche, **dadurch gekennzeichnet, dass** die verrundete Spitze (37) als wechselbare Gegendruckspitze (36) ausgebildet ist.

7. Verfahren zum Handhaben von Bauelementen, insbesondere elektronischen Bauelementen, mit folgenden Schritten:
- Ansaugen eines Bauelements per Unterdruck und Halten des Bauelements durch den Unterdruck;
- Abstützen des per Unterdruck gehaltenen Bauelements im Bereich seiner mit Unterdruck beaufschlagten Fläche derart, dass sich diese Fläche, insbesondere das Bauelement, von der Unterdruckseite her betrachtet, konkav durchbiegt,
- **dadurch gekennzeichnet, dass** ein Anlegen des Bauelements an den Rändern einer mit dem Unterdruck Beaufschlagten Halteöffnung erfolgt, wobei, in Saugrichtung betrachtet, das Abstützen stromaufwärts des Anlegens dadurch erfolgt, dass sich die Halteöffnung in Saugrichtung über eine längsverschiebliche Lagerung der Halteöffnung relativ zu einem Abstützpunkt, der das Bauelement flächenmittig abstützt, verschiebt

8. Verfahren nach Anspruch 7, **dadurch gekennzeichnet, dass** die Stärke des Unterdrucks einstellbar gewählt werden kann.

## Claims

1. Handling tool for components, in particular electronic components, having a holding opening to which negative pressure can be applied and at which components to be handled can be held by negative pressure, **characterized in that** in the holding opening (18) there is arranged at least one counter holder (8), which in an operating position protrudes outwards beyond the plane of the opening (20) and is passed through by at least one negative-pressure supply channel (9), and a sleeve (12) that comprises the holding opening (18) being mounted axially displaceably on the counter holder (8).

2. Handling tool according to Claim 1, **characterized in that** the sleeve (12) is axially displaceable against spring force.

3. Handling tool according to one of the preceding claims, **characterized in that** the negative pressure (P_{U}) can be controlled individually, in particular component-dependently, in its intensity by means of a control device.

4. Handling tool according to one of the preceding claims, **characterized in that** the counter holder (8) is arranged centrally in the holding opening (18).

5. Handling tool according to one of the preceding claims, **characterized in that** the counter holder (8) has a rounded tip (37), in particular a conical tip (19).

6. Handling tool according to one of the preceding claims, **characterized in that** the rounded tip (37) is formed as an exchangeable counter-pressure tip (36).

7. Method for handling components, in particular electronic components, comprising the following steps:
- sucking up a component by negative pressure and holding the component by the negative pressure;
- supporting the component held by negative pressure in the region of its surface to which negative pressure is applied in such a way that this surface, in particular the component, bends concavely, as viewed from the negative pressure side,
- **characterized in that** the component is placed against the edges of a holding opening to which the negative pressure is applied, the supporting taking place downstream of the placement, as viewed in the direction of the suction, by the holding opening being displaced in the direction of the suction by way of a longitudinally displaceable mounting of the holding opening in relation to a supporting point that supports the component in the middle of its surface.

8. Method according to Claim 7, **characterized in that** the intensity of the negative pressure can be chosen in a variable manner.

## Revendications

1. Outil de manipulation pour composants, notamment pour composants électroniques, comprenant une ouverture de retenue pouvant être soumise à une dépression, au niveau de laquelle des éléments à manipuler peuvent être maintenus par une dépression, **caractérisé en ce qu'**au moins une contre-butée (8) est disposée dans l'ouverture de retenue (18), laquelle contre-butée dépasse vers l'extérieur au-delà du plan de l'ouverture (20) dans une position de fonctionnement et est traversée par au moins un canal d'alimentation en dépression (9), et une douille (12) comprenant l'ouverture de retenue (18) étant montée de manière déplaçable axialement sur la contre-butée (8).

2. Outil de manipulation selon la revendication 1, **caractérisé en ce que** la douille (12) est déplaçable axialement à l'encontre d'une force de ressort.

3. Outil de manipulation selon l'une quelconque des revendications précédentes, **caractérisé en ce que** l'intensité de la dépression (Pu) peut être commandée individuellement, notamment en fonction de l'élément, au moyen d'un dispositif de commande.

4. Outil de manipulation selon l'une quelconque des revendications précédentes, **caractérisé en ce que** la contre-butée (8) est disposée de manière centrale dans l'ouverture de retenue (18).

5. Outil de manipulation selon l'une quelconque des revendications précédentes, **caractérisé en ce que** la contre-butée (8) comprend une pointe arrondie (37), notamment une pointe conique (19).

6. Outil de manipulation selon l'une quelconque des revendications précédentes, **caractérisé en ce que** la pointe arrondie (37) est réalisée sous forme de pointe de contre-pression (36) remplaçable.

7. Procédé de manipulation de composants, notamment de composants électroniques, comprenant les étapes suivantes :
- aspiration d'un composant par dépression et maintien du composant grâce à la dépression ;
- appui du composant maintenu par dépression dans la région de sa surface soumise à la dépression, de telle sorte que cette surface, notamment le composant, fléchisse de manière concave, vu du côté de la dépression,
- **caractérisé en ce qu'**une application du composant s'effectue sur les bords d'une ouverture de retenue soumise à la dépression, l'appui s'effectuant en amont de l'application, vu dans la direction d'aspiration, par le fait que l'ouverture de retenue se déplace dans la direction d'aspiration au moyen d'un support déplaçable longitudinalement de l'ouverture de retenue par rapport à un point d'appui qui supporte le composant au milieu de sa surface.

8. Procédé selon la revendication 7, **caractérisé en ce que** l'intensité de la dépression peut être sélectionnée de manière réglable.
